(19) Europäisches Patentamt
European Patent Office
Office européen des brevets

(11) **EP 2 608 414 A2**

(12) **EUROPÄISCHE PATENTANMELDUNG**

(43) Veröffentlichungstag:
**26.06.2013 Patentblatt 2013/26**

(21) Anmeldenummer: **12180374.6**

(22) Anmeldetag: **14.08.2012**

(51) Int Cl.:
**H03M 13/11** *(2006.01)*  **H03M 13/45** *(2006.01)*

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(30) Priorität: **15.08.2011 DE 102011110121**

(71) Anmelder: **Tropf, Hermann
68789 St. Leon-Rot (DE)**

(72) Erfinder: **Tropf, Hermann
68789 St. Leon-Rot (DE)**

(74) Vertreter: **Bettinger Schneider Schramm
Postfach 860267
81629 München (DE)**

(54) **Kanalcodierungsverfahren und Decodierungsverfahren**

(57) Verfahren zur Kanalcodierung einer Datenfolge, bestehend aus k Informationssymbolen $i_1, i_2, .. i_k$ jeweils aus einem Symbolvorrat von p Symbolen, wobei p eine Primzahl ist, wobei der Datenfolge zwei Paritätssymbole $p_1, p_2$ hinzugefügt werden, so dass eine Datenfolge mit n = k + 2 Symbolen entsteht, wobei die Paritätssymbole wie folgt berechnet werden:

$$p_1 = (i_1 \cdot f_1 + i_2 \cdot f_2 + .... + i_k \cdot f_k) \qquad (\text{Modulo } p)$$

$$p_2 = (i_1 \cdot g_1 + i_2 \cdot g_2 + .... + i_k \cdot g_k) \qquad (\text{Modulo } p)$$

wobei die Spalten

$$\frac{f_1 \quad f_2 \quad f_3 \quad \quad f_k}{g_1 \quad g_2 \quad g_3 \quad \quad g_k} , \; , \; , \; \cdots$$

paarweise linear unabhängig sind.

Fig. 2

EP 2 608 414 A2

**Beschreibung**

Die Erfindung betrifft ein Kanalcodierungsverfahren mit dazugehörigem Decodierungsverfahren sowie entsprechende Einrichtungen. Die Erfindung ist anwendbar sowohl auf eindimensionale Codierungen (z.B. elektrische Signale, Barcodes) als auch auf mehrdimensionale Codierungen (z.B. Beschriftungen auf Oberflächen mit Matrixcodes, einschließlich verformender Beschriftung von Oberflächen, prinzipiell auch für dreidimensionale Anordnungen von physikalischen Realisierungen der Code-Symbole).

In neuerer Zeit wurden Low Density Parity-Check Verfahren (LDPC) intensiv untersucht. LDPC-Codes arbeiten iterativ. Aus US 2004/0 163 030 A1 "Iterative Error Correcting System" (s. Fig. 3, 0024) ist eine Kanalkodierung bekannt, durch welche für Daten Paritäten berechnet werden und wobei diese Daten und Paritäten anschließend dazu verwendet werden, um weitere Paritäten zu berechnen. Aus US 2010/0 005 368 A1 (s. Fig. 3, 0038-0041) ist eine Kanalkodierung bekannt, durch welche für eine Datensequenz Basis-Paritäten berechnet werden und wobei aus diesen Basis-Paritäten Fragment-Paritäten berechnet werden.

Aufgabe der Erfindung ist es, bekannte Nachteile von LDPC und sonstiger iterativer Verfahren zumindest teilweise zu vermeiden. Die Aufgabe wird gelöst nach den unabhängigen Ansprüchen. Vorteilhafte Weiterbildungen der Erfindung sind in den jeweiligen abhängigen Ansprüchen definiert.

Erfindungsgemäß bereitgestellt wird also ein Verfahren zur Kanalcodierung einer Datenfolge, bestehend aus k Informationssymbolen $i_1, i_2, ..i_k$ jeweils aus einem Symbolvorrat von p Symbolen, wobei p eine Primzahl ist, wobei der Datenfolge zwei Paritätssymbole $p_1, p_2$ hinzugefügt werden, so dass eine Datenfolge mit n = k + 2 Symbolen entsteht, wobei die Paritätssymbole wie folgt berechnet werden:

$$p_1 = (i_1 * f_1 + i_2 * f_2 + .... + i_k * f_k) \qquad (Modulo\ p)$$

$$p_2 = (i_1 * g_1 + i_2 * g_2 + .... + i_k * g_k) \qquad (Modulo\ p)$$

wobei die Spalten

$$\frac{f_1}{g_1}, \frac{f_2}{g_2}, \frac{f_3}{g_3}, ... \frac{f_k}{g_k}$$

paarweise linear unabhängig sind.

Hierbei können die Werte für $f_i$ und $g_i$ wie folgt gewählt werden:

$$f_1 = f_2 = f_3 = ... = 1$$

$$g_1 = 1,\ g_2 = 2,\ g_3 = 3, ...,\ g_k = k;$$

Des Weiteren umfasst die Erfindung ein Verfahren zur Codierung einer Datenfolge bestehend aus K Informationssymbolen $i_1, i_2, ..i_K$ jeweils aus einem Symbolvorrat von p Symbolen, wobei p eine Primzahl ist, in ein Hauptcodewort,

wobei mehrere Einzel-Informationsworte erzeugt werden, indem die Informationssymbole so zusammengefasst werden, dass jeweils zwei beliebige Einzel-Infowörter maximal ein gemeinsames Symbol haben,

wobei aus den Einzel-Informationsworten jeweils Einzel-Codeworte erzeugt werden, die jeweils Datenfolgen sind, von denen zumindest einige mittels des zuvor beschriebenen Kanalcodierungsverfahrens gebildet werden, und wobei sich das Hauptcodewort aus den erzeugten Einzel-Codeworten ergibt.

Des Weiteren umfasst die vorliegende Erfindung auch ein Decodierungsverfahren für ein Haupt-Codewort, das gemäß dem zuvor beschriebenen Verfahren gebildet ist, wobei für jedes empfangene Symbol für jeden möglichen Symbolwert 0... p-1 ein Sicherheitswert erzeugt wird, mit folgenden Schritten:

a) Entsprechend der Anordnung der Informationssymbole und Paritätssymbole in den gebildeten Einzel-Codeworten werden die Sicherheitswerte den gebildeten Einzel-Codeworten zugeordnet, wobei sich Einzel-Sicherheitsworte ergeben;

b) Für alle Einzel-Sicherheitsworte werden die Decodiersicherheiten S 12 berechnet, das ist die Differenz zwischen dem Sicherheitswert des besten Einzel-Codeworts und dem Sicherheitswert des zweitbesten Einzel-Codeworts für dieses Einzel-Sicherheitswort;

c) Das Einzel-Codewort mit der höchsten Decodiersicherheit S 12 wird fixiert, d.h. seine Symbole werden fixiert, indem sie Werte entsprechend dem Decodierergebnis für dieses Einzel-Codewort erhalten; seine Sicherheitswerte der betreffenden Symbole werden entsprechend dem Decodierergebnis modifiziert, zumindest dann, wenn sich die betreffenden Symbole in noch weiteren Worten mit noch unfixierten Info-Symbolen befinden und sich durch das Fixieren die Sicherheitswerte wesentlich verändern;

d) Ausführen von Schritt b) für unfixierte Worte, die Symbole mit modifizierten Sicherheitswerten enthalten;

e) Wiederholen der Schritte c) und d), bis alle Informationssymbole fixiert sind;

f) Ausgeben der Informationssymbole als Decodierergebnis.

Bei dem Decodierungsverfahren können die Einzel-Sicherheitsworte aus einem redundanten Leitungscode gewonnen werden.

Die Erfindung umfasst auch Programmcode, der, wenn in eine Datenverarbeitungsvorrichtung geladen, das erfindungsgemäße Verfahren wie zuvor beschrieben zur Ausführung bringt.

Ferner umfasst die Erfindung auch einen maschinenlesbaren Datenträger mit Programmcode wie zuvor beschrieben.

Ferner umfasst die Erfindung auch ein elektrisches Signal, welches Programmcode wie zuvor beschrieben aufweist.

Ferner umfasst die Erfindung auch eine Datenverarbeitungsvorrichtung, die programmiert ist, eines der erfindungsgemäßen Verfahren auszuführen.

Schließlich umfasst die Erfindung noch ein elektrisches Signal, erzeugt unter Anwendung des erfindungsgemäßen Codierverfahrens.

Die Erfindung wird anhand von Beispielen und der Zeichnung näher beschrieben. In der Zeichnung zeigt

Fig. 1 ein Lösungsschema zur Decodierung eines zur besseren Erläuterung vereinfachten Einzelcodes gemäß der Erfindung; und

Fig. 2 ein Einzel-Codewort und ein Haupt-Codewort.

Das hier vorgestellte Codierverfahren für einen Code mit N Symbolen (Hauptcode) basiert auf der mehrfachen Anwendung einer Codierung mehrerer Codewörter eines zweiten Codes mit n < N Symbolen (Einzelcode). Das Soft-Decision-Decodierverfahren basiert auf einer mehrfach angewendeten Soft-Decision-Decodierung von Einzelcodes.

1. Einzelcode

1.1. Codierung Einzelcode

Der Symbolvorrat besteht aus p > 2 Symbolen, p ist eine Primzahl. Die möglichen Symbolwerte werden mit ihren Werten 0, 1,..., p - 1 dargestellt.

Die Einzel-Codeworte mit n Symbolen besitzen k Informationssymbole und n-k Redundanzsymbole in Form von Paritäten aus einer gewichteten Summe von Symbolwerten, kurz Paritätssymbole genannt.

Es gilt: $k \le p - (n - k) + 1$.

Berechnung der Paritätssymbole anhand eines Beispiels (p = 7, n = 8, k = 6) :

Die Informationssymbole sind i1, i2,..., i6, die Paritätssymbole sind p1, p2 Die Berechnung der Paritätssymbole erfolgt nach folgendem Schema, mit den Gewichtsfaktoren f1 , ..., f6; g1, ..., g6:

| i1 | i2 | i3 | i4 | i5 | i6 | p1 | p2 |
|----|----|----|----|----|----|----|----|
| f1 | f2 | f3 | f4 | f5 | f6 |    |    |
| g1 | g2 | g3 | g4 | g5 | g6 |    |    |

Paritäten:

$$p1 = (i1*f1 + i2*f2 + i3*f3 + i4*f4 + i5*f5 + i6*f6) \quad (Mod\ 7)$$

$$p2 = (i1*g1 + i2*g2 + i3*g3 + i4*g4 + i5*g5 + i6*g6) \quad (Mod\ 7)$$

Die Spalten der Gewichtsfaktoren im Schema bis i6 sind linear unabhängig (Modulo p). Es muss also gelten $f1*g2 \neq f2*g1, f2*g5 \neq f5*g2, ..$

Die Forderung ist beispielsweise erreichbar durch:

$$f1 = f2 = f3 = ...= f6 = 1;$$

$$g1 = 1, g2 = 2, g3 = 3,..., g6 = 6.$$

abkürzend geschrieben:

| f: | 1 | 1 | 1 | 1 | 1 | 1 |
|----|---|---|---|---|---|---|
| g: | 1 | 2 | 3 | 4 | 5 | 6 |

Der Einzelcode ist linear und hat mit 2 Paritätssymbolen einen Mindestabstand von 3. Herleitung: Ausgehend vom Nullwort ergibt die Änderung eines einzelnen Informationssymbols eine Änderung beider Paritätssymbole; Änderung von zwei Informationssymbolen ergibt aufgrund der linearen Unabhängigkeit die Änderung von mindestens einem Paritätssymbol.

Nach Erkenntnissen des Anmelders ist die Erweiterung auf mehrere Paritätssymbole möglich, die Anwendung im Rahmen der Erfindung ist aus Rechenzeit-Gründen auf zwei Paritätssymbole beschränkt (siehe "Decodierung Einzelcode"), beim Einsatz in dem weiter unten beschriebenen Hauptcode wird dennoch eine sehr gute Decodierleistung erreicht.

1.2. Decodierung Einzelcode:

Wie bei Soft-Decision-Methoden allgemein vorausgesetzt, wird an jeder Position pos = 1, ..., n für jeden möglichen Symbolwert 0, ..., p - 1 ein Sicherheitswert bereitgestellt oder berechnet, für jede Position steht also ein Vektor von Sicherheitswerten mit p Komponenten bereit. Die einzelnen Werte können dabei auch implizit repräsentiert sein, z.B. als Liste mit Werten oberhalb einer Schwelle (oder z.B. der drei höchsten Werte > 0) unter Auslassung aller anderen Werte, die anschließend rechnerisch zu Null gesetzt werden. Aufgabe ist es, das Codewort mit der maximalen Summe von Sicherheitswerten (Sicherheit S1) zu berechnen.

Die Lösung kann über Dynamische Optimierung geschehen auf einem entsprechenden Trellis.

Einschub: Zur Erleichterung des Verständnisses des Lösungsansatzes sei hier ein einfacheres Beispiel mit nur einem Paritätssymbol p1 eingeschoben, mit k=3 Informationssymbolen (also n=4, da nur ein Paritätssymbol) auf Basis der Primzahl p=3, und mit $f_1 = f_2 = f_3 = 1$; der Wert des Paritätssymbols ist also einfach die Summe der Werte der Informationssymbole 1...3, modulo 3, also

"Symbolposition:"

| 1 | 2 | 3 | 4 |
|---|---|---|---|
| i1 | i2 | i3 | p1 |
| f1 | f2 | f3 | |

mit

f: 1 1 1

Es handelt sich also bei p1 um ein einfaches modulo-3 Paritätssymbol.

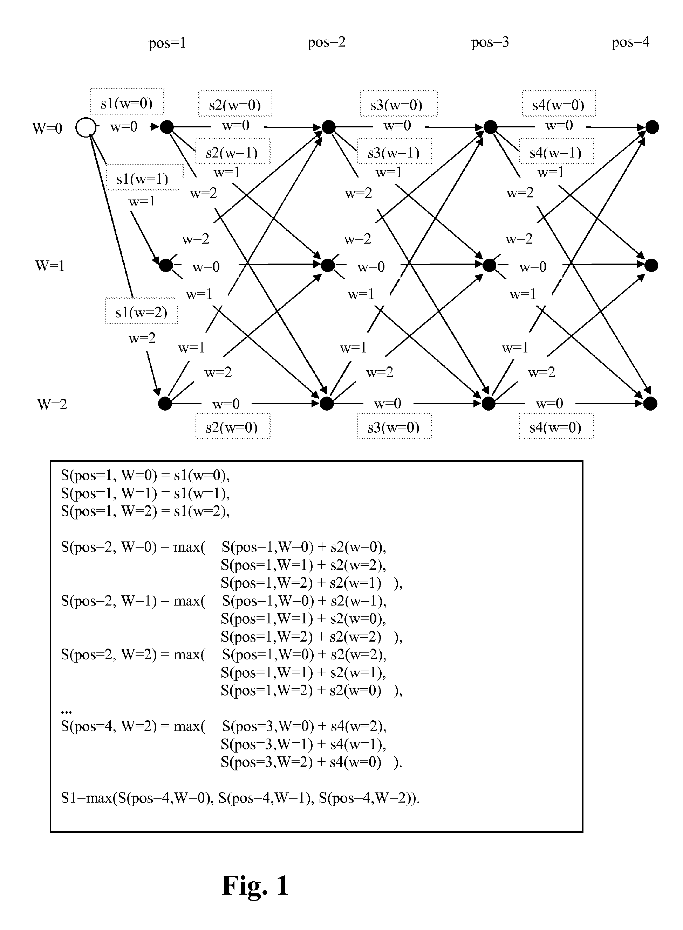

Die auf Dynamischer Optimierung basierende Vorgehensweise wird in Fig. 1 veranschaulicht. Für jede Position pos = 1, ..., 4 wird ein Vektor von Sicherheitswerten bereitgestellt oder berechnet mit 3 Elementen, bezeichnet mit s1(0... 2) ... s4(0...2), den Sicherheiten für die möglichen Paritätswerte 0...2 entlang des Weges bis pos = 1,...,4. Eine mögliche Realisierung des Trellis ist in Fig. 1 dargestellt. Es besteht aus einem (n mal p)-Feld von Knoten, wobei die Spalten den Symbolpositionen und die Zeilen den Paritätswerten W = 0...2 entsprechen, wie sie beim positionsweisen Berechnen der Parität entstehen. Zusätzlich wird hilfsweise ein Startknoten eingeführt. Das Trellis besitzt gerichtete Kanten vom Startknoten zu Knoten mit pos=1 und ansonsten zwischen Knoten aufeinanderfolgender Positionen. Von jedem Knoten gehen drei Kanten aus für die möglichen Symbolwerte (Hypothesen) w = 0...2 und diese Symbolwerte sind auch gekoppelt mit den betreffenden Sicherheitswerten s1(0...2)..s4(0...2). (Aus Platzgründen sind in Fig. 1 die Werte s2, s3...nicht alle eingezeichnet). Die Festlegung eines Codeworts entspricht einem Pfad vom Startknoten zu einem der Knoten bei pos = 4.

Die Struktur des Trellis spiegelt die Formel p1=1*i1 + 1*i2 + 1*i3 wider: Wie aus Fig. 1 ersichtlich, wird für das Weiterrechnen des Paritätswerts, der bis zu einer Position berechnet wurde, einfach der neue Paritätswert w modulo 3 addiert.

(Beispiel: w=2, führt von pos=1, W = 1, an pos=2 zu W=1+2 mod 3 = 0).

Für Gewichtsfaktoren >1 muss der neue Paritätswert zuvor mit dem Gewichtsfaktor multipliziert werden, mit entsprechender Modifikation im Trellis.

(Beispiel: f= 2, w = 2, führt von pos = 1, W = 0, an pos = 2 zu W = 0 + 2*2 mod 3 = 1), also allgemein Wneu = Walt + f*w (mod p).

Beim Durchlaufen des Trellis werden mittels Dynamischer Optimierung aus den Sicherheitswerten s die Sicherheitssummen S für jeden Knoten berechnet, entsprechend den Formeln in Fig. 1.

Die Decodierungslösung geschieht auf Basis dieses Trellis, indem in bekannter Weise mittels Dynamischer Optimierung der Weg durch das Trellis zu dem Knoten an pos = 4 mit maximaler Summe (=S1) bestimmt wird. Damit ist die Lösung für das Einschub-Beispiel für den Fachmann ausreichend beschrieben. Aus der Literatur bekannte Modifikationen oder Alternativen zur Realisierung und Abarbeitung eines Trellis werden hier nicht weiter aufgeführt.

Die Lösung für zwei Paritäten p 1 und p2 geschieht nach dem gleichen Prinzip, nur dass man an jeder Position statt eines Vektors von Paritäten (p = 0, ..., p-1) eine Matrix von Paritäten für alle möglichen Kombinationen (p1 = 0, ..., p-1, p2 = 0, ..., p-1) verwendet. Das Trellis wird nach dem gleichen Prinzip aufgebaut, nur mit Matrizen anstelle von Vektoren: So wie im vorigen einfachen Beispiel an irgendeiner Stelle pos=... eine Hypothese w = 0, ..., 2 zu modulo p gewichtet-Inkrementieren führt (Wneu = Walt + f*w, s.o.), mit entsprechenden Kanten im Trellis zwischen Vektorelementen, führt hier eine Hypothese w zu zweimaligem modulo p gewichtet-Inkrementieren, getrennt für p1 und p2 (W$_{p1}$neu = W$_{p1}$alt + f$_{p1}$*w, W$_{p2}$neu=Wp1alt + f$_{p2}$*w), mit entsprechenden Kanten im Trellis zwischen Matrixelementen.

Anmerkung: Für drei Paritätssymbole p1, p2, p3 würde sich dementsprechend ein Würfel von Sicherheitswerten ergeben, etc. Daraus ergibt sich, dass - ohne beschränkende Maßnahmen wie die z.B. die Einschränkung auf wenige Hypothesen mit großen Sicherheiten - die Komplexität exponentiell mit der Anzahl der Paritätssymbole wächst, weshalb grundsätzlich ein Hauptcode auf Basis eines Einzelcodes mit möglichst kleinem n-k anzustreben ist. Nach Erfahrung des Anmelders führt n-k = 2 bei ausreichend kurzer Rechenzeit und im Zusammenhang mit dem weiter unten beschriebenen Verfahren zu hoher Decodierungssicherheit in Anwesenheit von Störungen.

Erfindungsgemäß wird auch nach der zweitbesten Sicherheit S2 gesucht. Dies kann geschehen wie zuvor mittels Dynamischer Optimierung, jedoch unter Ausschluss des bereits gefundenen optimalen Pfades.

Im folgenden wird die Decodiersicherheit S12= S1-S2 verwendet.

2. Hauptcode

2.1. Codierung Hauptcode

Der Hauptcode besitzt K > k Informationssymbole.

Es werden mehrere Einzel-Informationsworte erzeugt, jeweils aus k Informationssymbolen, indem Informationssymbole so Einzel-Informationsworten zugeordnet werden, dass zwei beliebige Einzel-Infowörter maximal ein gemeinsames Symbol haben. Die Einzel-Informationsworte werden durch Paritätssymbole ergänzt, wie im Abschnitt "Einzelcode" beschrieben.

Hierzu kann man eine Matrix zu Hilfe nehmen (Hilfsmatrix), in der die Symbole der Informationsworte jeweils horizontal oder vertikal oder schräg steigend oder schräg fallend (optional sogar mit unterschiedlichen Steigungen, jeweils modulo k; für k = Primzahl ist das sehr einfach) angeordnet sind. Die Vorab-Anordnung der Informationssymbole in der Hilfsmatrix ist beliebig.

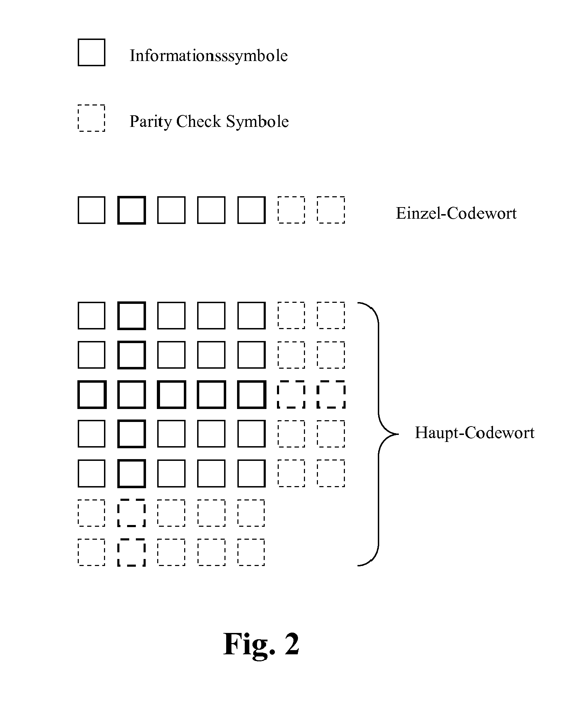

Fig. 2 zeigt eine solche Matrix mit k=5, n-k=2, mit 5 Einzel-Codeworten, mit je 5 Informationssymbolen (durchgezogen gezeichnet) und 2 Paritätssymbolen (gestrichelt gezeichnet) pro Einzel-Codewort und mit insgesamt K=25 Informationssymbolen in einer 5 x 5 - Anordnung. Um die Darstellung nicht zu kompliziert und dennoch das Prinzip verständlich zu machen wird in diesem Beispiel nur mit horizontalen und vertikalen Einzelcodeworten gearbeitet. In der Figur sind willkürlich ein horizontales und ein vertikales Einzel-Codewort mit dicken Linien hervorgehoben. Zwei beliebige Einzel-Infowörter haben maximal ein gemeinsames Symbol.

Die k x k - Matrix ist in dem Beispiel (n-k=2) wegen k ≤ p - (n-k)+1 maximal (p-1) * (p-1) groß. Damit ist auch die maximal mögliche Anzahl der Informationssymbole im Beispiel auf (p-1) * (p-1) beschränkt. Bevorzugt wird eine quadratische Matrix, mit jedoch ungerader Seitenlänge (es hat sich gezeigt, dass nach der im folgenden beschriebenen Vorgehensweise dadurch eine größere Mindestdistanz erreichbar ist).

Im folgenden Beispiel einer 5x5-Matrix sind 5 Einzel-Informationsworte mit je 5 Symbolen, gekennzeichnet mit 'a', 'b', ...'e', schräg fallend (modulo 5) angeordnet und 5 Einzel-Informationsworte mit je 5 Symbolen, gekennzeichnet mit 'f', 'g', ...'j', vertikal angeordnet; die Worte haben maximal ein gemeinsames Symbol, da sie sich maximal an einem Symbol kreuzen ("Kreuzungspunkte" im folgenden):

| a | e | d | c | b | | f | g | h | i | j |
|---|---|---|---|---|---|---|---|---|---|---|
| b | a | e | d | c | | f | g | h | i | j |
| c | b | a | e | d | | f | g | h | i | j |
| d | c | b | a | e | | f | g | h | i | j |
| e | d | c | b | a | | f | g | h | i | j |

Zusätzlich können natürlich horizontale und schräg steigende Einzel-Codeworte definiert werden. Es sind auch viele andere Anordnungen möglich (z.B. "Rösselsprung"), die die Forderung "maximal ein gemeinsames Symbol bei zwei beliebigen Einzel-Codeworten" einhalten.

Zu jedem der Informationsworte werden die zugehörigen Paritätssymbole p1 und p2 berechnet nach der oben angegebenen Methode, die Einzel-Informationsworte damit zu Einzel-Codeworten ergänzt.

Das Hauptcodewort besteht nun aus den K Informationssymbolen und allen Paritätssymbolen.

2.2. Scrambling Hauptcode

Zur Signalübertragung bzw. zweidimensionalen Darstellung werden die Symbole in einer solchen Reihenfolge angeordnet, dass Symbole, die zu einem der Einzel-Codewörter gehören, möglichst weit auseinander liegen (bei Zeitsignalen oder 1D-optischen Codes eindimensional gesehen, bei 2D-optischen Codes zweidimensional gesehen).

2.3. Modulation Hauptcode mit Leitungscode

Die Symbole des Hauptcodewortes werden mit einem eindimensionalen Leitungscode (insbes. bei Zeitsignalen) bzw. einem entsprechenden mehrdimensionalen weiteren Code (insbes. bei optisch lesbaren Codes in Bildern) moduliert, auch im letzteren Fall verallgemeinernd Leitungscode genannt. Anmerkung: "eindimensional/mehrdimensional" bezieht sich hier auf die Anordnung der Symbole in der betreffenden Anwendung. Unabhängig davon können die Symbole selbst technisch eindimensional oder mehrdimensional realisiert im Sinne der Signalverarbeitung sein (Beispiel für mehrdimensionale technische Realisierung eines eindimensionalen Signals: Modulation von Amplitude und Phase).

2.4. Decodierung Hauptcode

Für jedes empfangene Symbol wird, bevorzugt unter Zuhilfenahme des Leitungscodes, für jeden möglichen Symbolwert 0..p-1 ein Sicherheitswert berechnet bzw. ist vorab bereitgestellt.

Entsprechend der Zuordnung der Informationssymbole und Paritätssymbole zu den Einzel-Codewörtern des Codierens (ggf. unter Berücksichtigung des bekannten Scrambling) werden diese Sicherheitswerte den Einzelcodeworten zugeordnet. Daraus ergeben sich - analog zu den Einzelcodeworten - Einzel-Sicherheitsworte.

Nun werden für alle Einzel-Sicherheitsworte die Decodiersicherheiten S12 berechnet, wie oben beschrieben.

Das Wort mit dem höchsten S12 wird "fixiert", d.h. seine Symbole erhalten festgelegte Werte entsprechend dem Decodierergebnis für dieses Wort; die Sicherheitswerte dieses Wortes werden entsprechend dem Decodierergebnis modifiziert: die Sicherheitswerte von fixierten Symbolen nehmen für den Symbolwert des Decodierergebnisses einen hohen Wert an, für die restlichen Symbolwerte den Wert Null oder einen sehr kleinen (ggf. negativen) Wert.

Dieser Vorgang wird wiederholt, bis alle Informationssymbole fixiert sind. Diese werden dann als Decodierergebnis ausgegeben.

Dabei genügt es zur Beschleunigung i.a., falls beim Fixieren Sicherheitswerte von Symbolen wesentlich verändert wurden, nur für noch nicht fixierte Worte, die solche Symbole enthalten, die Decodiersicherheiten S12 neu zu berechnen. Bei diesem Vorgang sind also diverse beschleunigende Maßnahmen möglich. Beispielsweise müssen auch nicht alle Sicherheitsworte neu decodiert werden: wenn sie sich entweder mit zuvor fixierten Worten nicht kreuzen oder wenn an den Kreuzungsstellen die Decodiersicherheiten nicht wesentlich verändert wurden, können die Werte S 12 aus dem letzten Zyklus wiederverwendet werden. Außerdem brauchen Sicherheitswerte von zuvor bereits fixierten Symbolen nicht aktualisiert zu werden.

Falls das höchste S12 = 0 ist liegt eine mehrdeutige Einzellösung vor und der Decodiervorgang kann frühzeitig abgebrochen werden.

3. Schluss

Die Methode ist sehr robst gegen Störungen unterschiedlichster Art. Im Vergleich zur Vorgehensweise bei LDPC-Codes weisen auch kleine Codes eine gute Performance auf (LDPC-Codes sind mit n<100 schlecht und erst ab ca. n=10000 wirklich gut). Die Anzahl der mindestens korrigierbaren Symbole und damit der Mindestabstand ist im Gegensatz zu LDPC leicht berechenbar (Hinweis: Verwendung der oben aufgeführten Hilfsmatrix; Betrachtung der Kreuzungsmöglichkeiten von mehreren Worten, so dass bei allen diesen Worten zwei oder mehr Kreuzungssymbole auftreten. Wenn alle diese Kreuzungssymbole gestört sind, sind die Worte nicht rekonstruierbar). Bei p=7 und 5 x 5 Informationssymbolen und 4 Gruppen von Einzelcodewörtern (horizontal, vertikal, steigend, fallend) können mindestens 5 Symbole korrigiert werden, der Mindestabstand ist also 11. Entsprechend Computersimulationen ist die Wahrscheinlichkeit, dass eine solche Störungssituation auftritt, in der 6 oder geringfügig mehr gestörte Symbole nicht korrigiert werden können, sehr gering und liegt bei p>10 im Promillebereich, für größere Hilfsmatrizen von Informationssymbolen (und entsprechend großem p) im ppm-Bereich. Ein solcher Code ist also auch sehr gut geeignet für Situationen, in denen es möglich ist, die Übertragung auf Anforderung zu wiederholen (entspricht z.B. beim Lesen von optischen Codes einem erneuten Leseversuch bei Handscannern oder Leseversuch mit veränderter Beleuchtung), da die Notwendigkeit zur Wiederholung nur sehr selten auftreten wird. Das Codieren ist im Gegensatz zu LDPC sehr einfach (bei nichttrivialen LDPC bereitet beim Codieren die Unterscheidung der Informationssymbole von den restlichen Symbolen Schwierigkeiten).

Das Decodierverhalten ist im Gegensatz zu LDPC transparent und deshalb je nach spezieller Aufgabenstellung durch technische Maßnahmen gezielt beeinflussbar.

Die Berechnung der Sicherheitswerte kann mit bekannten Techniken direkt aus dem Signal erfolgen, z.B. durch Korrelation mit störungsfreien Standardsignalen. Übertragungseinrichtungen arbeiten meist mit binären oder mehrstufigen Leitungscodes, die selbst redundant sind, z.B. 4B5B (4 Datenbits entsprechend 16 möglichen Symbolwerten, 5 Codebits). Solche Leitungscodes sind teilweise zur Vorab-Fehlererkennung geeignet und/oder zur Taktgewinnung. Aufgrund Erfahrungen des Anmelders eignen sich redundante Leitungscodes besonders gut zur Bereitstellung der Sicherheitswerte, insbesondere wenn sie mittelwertfrei sind. Leitungscodes, bei denen die Anzahl möglicher Symbolwerte einer Primzahl >2 entspricht, sind zwar unüblich, aber leicht realisierbar und direkt für die hier vorgestellte Vorgehensweise verwendbar. Die Vorab-Decodierung der Leitungsgcodes (Demodulation) kann unmittelbar die Sicherheitswerte für die Sicherheitsworte liefern. Je höher die Redundanz des Leitungscodes, desto signifikanter die Sicherheitswerte und desto sicherer die Gesamt-Decodierung. Auch zur Soft-Decodierung von Leitungscodes ist die Gewinnung oder Berechnung von Sicherheitswerten erforderlich; somit können bei dieser Erfindung zur Gewinnung von Sicherheitswerten aus Leitungscodes alle aus der Literatur bekannten Soft-Decodierungsverfahren herangezogen werden.

Bei dem unten beschriebenen Soft-Decision-Verfahren zu diesem Code steigt die Zeitkomplexität exponentiell mit (n-k). Für das Decodieren des Hauptcodes hat sich n-k=2 nach Erfahrung des Anmelders als völlig ausreichend erwiesen. Die Wahl der Gewichtsfolgen 1, 1, 1... und 1, 2, 3,... kommt einer zeitoptimierten Realisierung entgegen.

Die Praxis hat gezeigt, dass der Hauptcode auf Basis eines Einzelcodes mit n - k = 2 zu sehr guten Decodierergebnissen führt, bei noch guten Rechenzeiten, während mit n - k = 1 die Ergebnisse drastisch schlechter werden. Nach Erfahrung des Anmelders verbessert die Verwendung von S12 anstelle von S1 (was grundsätzlich möglich wäre) die Decodierergebnisse erheblich.

Viele ergänzende Modifikationen sind möglich; der Fachmann wird je nach Bedürfnissen der Anwendung entsprechende Modifikationen realisieren. Dem kommt die Transparenz der Wirkungsweise des beschriebenen Verfahrens ganz besonders entgegen.

Beispielsweise kann unter Einhaltung der Vorgehensweise durch Einführung zusätzlicher Einzelcodewörter, deren Informationssymbole nunmehr zumindest teilweise aus bisher beschriebenen Paritätssymbolen bestehen, und die zusätzliche Paritätssymbole besitzen, weiter gesteigert werden. Auch kann natürlich die Codewortlänge n für die verschiedenen Einzelcodes unterschiedlich sein.

Zumindest einige der Einzel-Codeworte sind mittels des oben unter 1.1 beschriebenen Verfahrens mit n-k=2, codiert, für den Rest sind grundsätzlich alle Einzelcodes verwendbar, die Soft-Decision decodiert werden können. Bezüglich eines guten Kompromisses zwischen Störsicherheit und Geschwindigkeit kann die Kombination einiger Einzelcodes mit n - k = 2 mit solchen mit n - k = 1 günstig sein (bei Einzelcodes mit n - k = 1 sind nur einzelne Löschungen und keine Vertauschungen korrigierbar; das oben beschriebene Verfahren ist für Einzelcodes mit n - k = 1 dementsprechend abzuändern). Die Einzelcodes mit n - k = 2 werden hierbei vorteilhaft so gewählt, das jedes Informationssymbol mindestens einmal von solch einem Einzelcode erfasst wird.

Überhaupt sind für den Hauptcode grundsätzlich alle Einzelcodes verwendbar, die Soft-Decision decodiert werden können - vorteilhaft, aber nicht notwendigerweise zu einer Sicherheit S12, jedoch haben sich die hier beschriebenen Einzelcodes, auch wegen ihrer Einfachheit, besonders bewährt. Auch ist eine Kombination der hier beschriebenen Einzelcodes mit anderen Einzelcodes möglich.

**Patentansprüche**

1. Verfahren zur Kanalcodierung einer Datenfolge, bestehend aus k Informationssymbolen $i_1, i_2, ... i_k$ jeweils aus einem Symbolvorrat von p Symbolen, wobei p eine Primzahl ist,
   wobei der Datenfolge zwei Paritätssymbole $p_1, p_2$ hinzugefügt werden, so dass eine Datenfolge mit n= k+2 Symbolen entsteht,
   wobei die Paritätssymbole wie folgt berechnet werden:

$$p_1 = (i_1 * f_1 + i_2 * f_2 + .... + i_k * f_k) \qquad (Modulo\ p)$$

$$p_2 = (i_1 * g_1 + i_2 * g_2 + .... + i_k * g_k) \qquad (Modulo\ p)$$

wobei die Spalten

$$\frac{f_1}{g_1}, \frac{f_2}{g_2}, \frac{f_3}{g_3}, ... \frac{f_k}{g_k}$$

paarweise_linear unabhängig sind.

2. Verfahren zur Kanalcodierung nach Anspruch 1, mit

$$f_1 = f_2 = f_3 = ... = 1$$

$$g_1 = 1, \ g_2 = 2, \ g_3 = 3, ... g_k = k;$$

3. Verfahren zur Codierung einer Datenfolge bestehend aus K Informationssymbolen $i_1, i_2, ... i_K$ jeweils aus einem Symbolvorrat von p Symbolen, wobei p eine Primzahl ist, in ein Hauptcodewort,
   wobei mehrere Einzel-Informationsworte erzeugt werden, indem die Informationssymbole so zusammengefasst werden, dass jeweils zwei beliebige Einzel-Infowörter maximal ein gemeinsames Symbol haben,
   wobei aus den Einzel-Informationsworten jeweils Einzel-Codeworte erzeugt werden, die jeweils Datenfolgen sind, von denen zumindest einige mittels des Verfahrens gemäß einem der vorherigen Ansprüchen gebildet werden,
   und wobei sich das Hauptcodewort aus den erzeugten Einzel-Codeworten ergibt.

4. Decodierungsverfahren für ein Haupt-Codewort, das gemäß dem Verfahren nach Anspruch 3 gebildet ist, wobei für jedes empfangene Symbol für jeden möglichen Symbolwert 0... p-1 ein Sicherheitswert erzeugt wird, mit folgenden Schritten:

   a) Entsprechend der Anordnung der Informationssymbole und Paritätssymbole in den gebildeten Einzel-Codeworten werden die Sicherheitswerte den gebildeten Einzel-Codeworten-zugeordnet, wobei sich Einzel-Sicherheitsworte ergeben;
   b) Für alle Einzel-Sicherheitsworte werden die Decodiersicherheiten S 12 berechnet, das ist die Differenz zwischen dem Sicherheitswert des besten Einzel-Codeworts und dem Sicherheitswert des zweitbesten Einzel-Codeworts für dieses Einzel-Sicherheitswort;
   c) Das Einzel-Codewort mit der höchsten Decodiersicherheit S 12 wird fixiert, d.h. seine Symbole werden fixiert, indem sie Werte entsprechend dem Decodierergebnis für dieses Einzel-Codewort erhalten; seine Sicherheitswerte der betreffenden Symbole werden entsprechend dem Decodierergebnis modifiziert, zumindest dann, wenn sich die betreffenden Symbole in noch weiteren Worten mit noch unfixierten Info-Symbolen befinden und sich durch das Fixieren die Sicherheitswerte wesentlich verändern;

d) Ausführen von Schritt b) für unfixierte Worte, die Symbole mit modifizierten Sicherheitswerten enthalten;
e) Wiederholen der Schritte c) und d), bis alle Informationssymbole fixiert sind;
f) Ausgeben der Informationssymbole als Decodierergebnis.

5. Decodierungsverfahren nach Anspruch 5, **dadurch gekennzeichnet, dass** die Einzel-Sicherheitsworte aus einem redundanten Leitungscode gewonnen werden.

6. Programmcode, der, wenn in eine Datenverarbeitungsvorrichtung geladen, das Verfahren gemäß einem der vorherigen Ansprüche zur Ausführung bringt.

7. Maschinenlesbarer Datenträger mit Programmcode gemäß Anspruch 6.

8. Elektrisches Signal, welches Programmcode gemäß Anspruch 6 aufweist.

9. Datenverarbeitungsvorrichtung, die programmiert ist, das Verfahren gemäß einem der Ansprüche 1 bis 3 auszuführen.

10. Elektrisches Signal, erzeugt unter Anwendung des Verfahrens gemäß einem der Ansprüche 1 bis 3.

pos=1        pos=2        pos=3        pos=4

S(pos=1, W=0) = s1(w=0),
S(pos=1, W=1) = s1(w=1),
S(pos=1, W=2) = s1(w=2),

S(pos=2, W=0) = max(   S(pos=1,W=0) + s2(w=0),
                       S(pos=1,W=1) + s2(w=2),
                       S(pos=1,W=2) + s2(w=1)  ),
S(pos=2, W=1) = max(   S(pos=1,W=0) + s2(w=1),
                       S(pos=1,W=1) + s2(w=0),
                       S(pos=1,W=2) + s2(w=2)  ),
S(pos=2, W=2) = max(   S(pos=1,W=0) + s2(w=2),
                       S(pos=1,W=1) + s2(w=1),
                       S(pos=1,W=2) + s2(w=0)  ),
...
S(pos=4, W=2) = max(   S(pos=3,W=0) + s4(w=2),
                       S(pos=3,W=1) + s4(w=1),
                       S(pos=3,W=2) + s4(w=0)  ).

S1=max(S(pos=4,W=0), S(pos=4,W=1), S(pos=4,W=2)).

# Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040163030 A1
- US 20100005368 A1